# EUROPÄISCHE PATENTSCHRIFT

(11) **EP 2 473 859 B1**
(45) Veröffentlichungstag und Bekanntmachung des Hinweises auf die Patenterteilung: **31.10.2012**
(21) Anmeldenummer: 10750066.2
(22) Anmeldetag: 31.08.2010
(51) Int. Cl.: G01R 1/067

(54) **HF-Messspitze**
HF test prod
Pointe de mesure HF

(30) Priorität: 02.09.2009 DE 202009011899 U
(43) Veröffentlichungstag der Anmeldung: 11.07.2012
(73) Patentinhaber: Rosenberger Hochfrequenztechnik GmbH & Co. KG, 83413 Fridolfing (DE)
(72) Erfinder: THIES, Steffen, A-5122 Überackern (AT)
(74) Vertreter: Zeitler - Volpert - Kandlbinder
(86) Internationale Anmeldenummer: PCT/EP2010/005353
(87) Internationale Veröffentlichungsnummer: WO 2011/026608

(56) Entgegenhaltungen:
- EP-A1- 0 685 742
- WO-A1-98/54586
- US-A- 3 317 830
- US-A1- 2004 100 295
- US-B1- 6 310 483

## Beschreibung

Die vorliegende Erfindung betrifft eine HF-Messspitze mit einem Gehäuse und einer Kontakteinheit zum elektrischen Kontaktieren mindestens einer Kontaktstelle eines Prüflings, wobei zwischen dem Gehäuse und der Kontakteinheit eine diese elektrisch und mechanisch verbindende HF-Koaxialleitung angeordnet ist, die einen Außenleiter, einen koaxial zum Außenleiter angeordneten Innenleiter und ein zwischen Außenleiter und Innenleiter angeordnetes Dielektrikum aufweist, gemäß dem Oberbegriff des Anspruchs 1.

Bei HF-Messspitzen der o.g. Art ist mit der Kontakteinheit, welche entsprechende Kontaktelemente aufweist, ein elektrischer Kontakt zu Kontaktstellen, wie eine planare Leiterstruktur, eines Prüflings herzustellen, wobei für den elektrischen Kontakt eine Kontaktfläche und eine Kontaktkraft notwendig sind. Zur wiederholbaren Herstellung einer vorbestimmten Kontaktkraft sind üblicherweise federnde Kontaktelemente an der Kontakteinheit der HF-Messspitzen vorgesehen. Bei hohen Frequenzen müssen jedoch diese Kontaktelemente aus elektrischen Gründen derart kurz ausgebildet sein, dass kein ausreichender Federweg mehr an den Kontaktelementen selbst zur Verfügung steht.

Aus der Druckschrift US 2007/0159196 A1 ist eine gattungsgemäße Messspitze bekannt, bei der die HF-Leitung als Koaxialkabel ausgebildet ist. Hierbei kann auch die Koaxialleitung eine Federfunktion für die Kontaktierung der Kontakteinheit zur Verfügung stellen. Dies hat jedoch den Nachteil, dass aufgrund einer temperaturabhängigen Länge des Koaxialkabels eine Impedanz und eine elektrische Länge, die eine Phasenlage eines übertragenen HF-Signal beeinflusst, nicht in der ggf. erforderlichen Genauigkeit gehalten werden kann. Weiterhin zeigt das Koaxialkabel beim Ein- und Ausfedern eine Hysterese, was die elektrischen Eigenschaften der Kontaktierung zusätzlich in nicht vorhersehbarer Weise beeinflusst.

Der Erfindung liegt die Aufgabe zugrunde, eine Messspitze der o.g. Art dahingehend zu verbessern, dass auch für Anwendungen mit hohen Frequenzen von 110 GHz oder mehr eine sichere Kontaktierung durch die Kontakteinheit sowie eine zuverlässige Signalübertragung über die Messspitze zur Verfügung steht.

Diese Aufgabe wird erfindungsgemäß durch eine Messspitze der o.g. Art mit den in Anspruch 1 gekennzeichneten Merkmalen gelöst. Vorteilhafte Ausgestaltungen der Erfindung sind in den weiteren Ansprüchen beschrieben.

Bei einer Messspitze der o.g. Art ist es erfindungsgemäß vorgesehen, dass der Außenleiter als Hohlprofil aus einem starren, elastisch verformbaren Werkstoff ausgebildet ist, wobei der Innenleiter koaxial zu diesem Hohlprofil angeordnet ist, wobei das Dielektrikum Gas oder Vakuum ist

Dies hat den Vorteil, dass nur noch der als Hohlprofil ausgebildete Außenleiter eine Federfunktion für die Kontaktierung der Messspitze zur Verfügung stellt, so dass Federweg und Federkonstante über eine Wahl von Art, Länge und Dicke des Werkstoffes für das Hohlprofil sehr genau einstellbar sind. Eine Hysterese bei der elastischen Verformung ist wirksam vermieden. Hierdurch erzielt man eine genau vorbestimmte Impedanz und elektrische Länge der HF-Koaxialleitung, wobei die Impedanz und elektrische Länge weitgehend unabhängig von dem Federweg und einer Umgebungstemperatur ist. Die Kontakteinheit selbst muss nur noch einen Höhenausgleich zur Verfügung stellen.

In einer bevorzugten Ausführungsform weist die HF-Leitung mindestens zwei oder mehr Innenleiter und/oder Außenleiter auf.

Eine besonders gute Entkopplung des Innenleiters von der Federfunktion erzielt man dadurch, dass der Innenleiter über mindestens einen vorbestimmten Abschnitt des Hohlprofils freitragend innerhalb des Hohlprofils angeordnet ist.

Eine stabile Fixierung des Innenleiters innerhalb des Hohlprofils erzielt man dadurch, dass der Innenleiter mit einem Ende an dem Gehäuse und mit dem anderen Ende an der Kontakteinheit befestigt ist.

Eine besonders gute Signalübertragung erzielt man dadurch, dass der Innenleiter über seine gesamte Länge zwischen dem Gehäuse und der Kontakteinheit von dem Hohlprofil koaxial umgeben und von diesem beabstandet ist.

Zum Einstellen von vorbestimmten elektrischen Eigenschaften der HF-Leitung ist der Innenleiter und/oder das den Außenleiter ausbildende Hohlprofil im Querschnitt vieleckig, rechteckig, dreieckig, oval oder rund ausgebildet.

Eine besonders gute Signalübertragung erzielt man dadurch, dass der Außenleiter als Rohr ausgebildet ist.

Die Erfindung wird im Folgenden anhand der Zeichnung näher erläutert. Diese zeigt in:
- Fig. 1: eine bevorzugte Ausführungsform einer erfindungsgemäßen Messspitze in perspektivischer Ansicht,
- Fig. 2: eine Schnittansicht eines HF-Leiters einer erfindungsgemäßen Messspitze gemäß einer bevorzugten Ausführungsform und
- Fig. 3: eine Schnittansicht eines HF-Leiters einer erfindungsgemäßen Messspitze gemäß einer weiteren bevorzugten Ausführungsform.

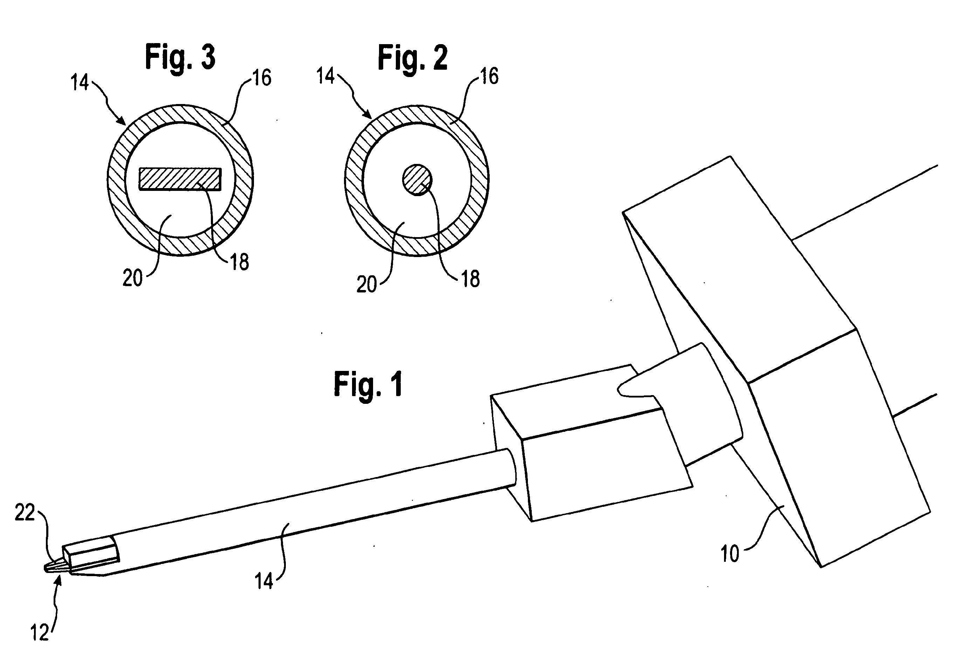

Die in Fig. 1 dargestellte, bevorzugte Ausführungsform einer erfindungsgemäßen Messspitze umfasst ein Gehäuse 10 und eine Kontakteinheit 12 zum elektrischen Kontaktieren mindestens einer Kontaktstelle eines Prüflings (nicht dargestellt). Zwischen dem Gehäuse 10 und der Kontakteinheit 12 ist eine diese elektrisch und mechanisch miteinander verbindende HF-Koaxialleitung 14 angeordnet.

Wie aus Fig. 2 hervorgeht, weist die HF-Koaxialleitung 14 einen Außenleiter 16, einen koaxial zum Außenleiter angeordneten Innenleiter 18 und ein zwischen Außenleiter 16 und Innenleiter 18 angeordnetes Dielektrikum 20 auf. Erfindungsgemäß ist das Dielektrikum 20 ein Gas, insbesondere Luft bzw. Stickstoff, oder ein Vakuum und der Außenleiter 16 ist als Hohlprofil in Form eines Rohres mit einem runden Querschnitt aus einem starren, jedoch elastisch verformbaren Werkstoff ausgebildet. Dementsprechend weist das Dielektrikum im Gegensatz zu einem herkömmlichen Koaxialkabel keine Haltefunktion für den Innenleiter 18 innerhalb des Außenleiters 16 auf. Der Innenleiter 18 ist freitragend innerhalb des starren Rohres 16 angeordnet, d.h. über die gesamte Länge des starren Rohres 16 bzw. über die Länge des Innenleiters 18 zwischen dem Gehäuse 10 und der Kontakteinheit 12 ist der Innenleiter 18 von dem starren Rohr 16 beabstandet und es sind keine Stützen vorgesehen, die den Innenleiter 18 gegen das starre Rohr 16 abstützen. Zur Halterung des Innenleiters 18 ist dieser lediglich mit dem Gehäuse 10 und der Kontakteinheit 12 mechanisch sowie elektrisch verbunden. In einer alternativen, nicht dargestellten Ausführungsform sind ggf. Stützen vorgesehen.

Die Kontakteinheit 12 weist drei Kontaktelemente 22 auf, die jeweilige freie Enden zum Kontaktieren von Kontaktstellen auf einem Prüfling aufweisen und die an die Frequenz der über die Messspitze zu übertragenden HF-Signale angepasst sind. Die Anordnung von drei Kontaktelementen 22 ist lediglich beispielhaft. Es können auch zwei sowie vier, fünf oder mehr Kontaktelemente 22 vorgesehene seien. Für hohe Frequenzen, beispielsweise größer oder gleich 110 GHz, sind diese Kontaktelemente 22 sehr kurz ausgebildet. Zwar können diese Kontaktelemente 22 beim Aufsetzen auf entsprechende Kontaktstellen eines Prüflings einen Höhenausgleich zwischen den Kontaktstellen zur Verfügung stellen, jedoch reicht deren Länge nicht mehr aus, um durch ein entsprechendes Federn aus einer Ruhestellung heraus beim Aufsetzen der Messspitze auf den Prüfling auch einen entsprechenden und wiederholbar identischen Kontaktdruck zur Verfügung zu stellen.

Die erfindungsgemäße Ausbildung der Messspitze ermöglicht, dass die Federfunktion zum Erzeugen eines vorbestimmten und wiederholbaren Kontaktdruckes sowie einer Kontaktfläche zwischen jeweils einer Kontaktstelle und einem Kontaktelement 22 durch den Außenleiter 16 in Form des Rohres zur Verfügung gestellt wird. Hierbei federt jedoch nur der Außenleiter 16, da durch die freitragende Anordnung des Innenleiters 18 dieser mechanisch im Wesentlichen von dem Außenleiter 16 entkoppelt ist. Hierdurch wird der Kontaktdruck allein durch eine Wahl des Werkstoffes für den Außenleiter 16 sowie durch dessen Länge, Form und Wandstärke eingestellt.

Ist das Dielektrikum Luft bzw. Stickstoff, so handelt es sich bei der HF-Koaxialleitung 14 um eine Luftleitung.

Der erfindungsgemäß ausgebildete Außenleiter 16 federt ohne Hysterese aus einer ausgelenkten Stellung wieder in seine Ruheposition zurück. Bei geeigneter Wahl des Werkstoffes für den Außenleiter 16 ergibt sich eine niedrige Temperaturempfindlichkeit der Impedanz und der elektrischen Länge der HF-Koaxialleitung 14. Die Impedanz kann sehr genau eingestellt und gehalten werden und es ergeben sich geringe Verluste.

In Fig. 2 ist der Innenleiter 18 beispielhaft mit einem runden Querschnitt dargestellt. Gemäß einer anderen Ausführungsform weist der Innenleiter eine rechteckige Querschnittsform auf, wie beispielhaft in Fig. 3 dargestellt.

Diese erfindungsgemäße Messspitze ist kostengünstig und präzise auch in Serienfertigung herstellbar und stellt eine Impedanzkontrolle zur Verfügung, so dass sich geringe Reflektionen bei der Kontaktierung mit einer beispielsweise planaren Struktur auf einem Prüfling zu Messzwecken ergeben. Die Kontaktelemente 22 der Kontakteinheit 12 sind als Koplanarleitung ausgebildet. Die erfindungsgemäße Messspitze zeichnet sich durch Betriebsfrequenzen von 110 GHz und höher aus, wobei die Impedanz über die gesamte koplanare Leiterstruktur der Kontakteinheit 12 im Wesentlichen dispersionsfrei, d.h. unabhängig von der Betriebsfrequenz, ist. Durch die frei federnde Ausbildung des Außenleiters 16 unabhängig vom Innenleiter 18 ist eine hohe Kontaktqualität zwischen allen Leitern 22 der koplanaren Leiterstruktur der Kontakteinheit 12 und entsprechenden Kontaktstellen einer zu prüfenden Einrichtung trotz kurzer und hierfür einen nicht ausreichenden Federweg aufweisenden Kontaktelementen 22 gewährleistet, wobei die Kontaktqualität unempfindlich bzgl. eines verkippten Aufsetzens der Messspitze auf die Kontaktstellen einer planaren Struktur eines Prüflings ist. Der nicht ausreichende Federweg der Kontaktelemente 22 ergibt sich aufgrund der HF-technischen Notwendigkeit, diese Kontaktelemente 22 für die Anwendung bei HF-Signalen mit hoher Frequenz (größer oder gleich 110 GHz) sehr kurz ausbilden zu müssen.

## Patentansprüche

1. HF-Messspitze mit einem Gehäuse (10) und einer Kontakteinheit (12) zum elektrischen Kontaktieren mindestens einer Kontaktstelle eines Prüflings, wobei zwischen dem Gehäuse (10) und der Kontakteinheit (12) eine diese elektrisch und mechanisch verbindende HF-Koaxialleitung (14) angeordnet ist, die einen Außenleiter (16), einen koaxial zum Außenleiter (16) angeordneten Innenleiter (18) und ein zwischen Außenleiter (16) und Innenleiter (18) angeordnetes Dielektrikum (20) aufweist,
**dadurch gekennzeichnet,**
**dass** der Außenleiter (16) als Hohlprofil aus einem starren, elastisch verformbaren Werkstoff ausgebildet ist, wobei der Innenleiter (18) koaxial zu diesem Hohlprofil angeordnet ist und das Dielektrikum (20) Gas oder Vakuum ist.

2. HF-Messspitze nach Anspruch 1, **dadurch gekennzeichnet, dass** die HF-Koaxialleitung (14) mindestens zwei oder mehr Innenleiter (18) aufweist.

3. HF-Messspitze nach Anspruch 1 oder 2, **dadurch gekennzeichnet, dass** die HF-Koaxialleitung (14) mindestens zwei oder mehr Außenleiter (16) aufweist.

4. HF-Messspitze nach mindestens einem der vorhergehenden Ansprüche, **dadurch gekennzeichnet, dass** der Innenleiter (18) über mindestens einen vorbestimmten Abschnitt des Hohlprofils (16) freitragend innerhalb des Hohlprofils (16) angeordnet ist.

5. HF-Messspitze nach mindestens einem der vorhergehenden Ansprüche, **dadurch gekennzeichnet, dass** der Innenleiter (18) mit einem Ende an dem Gehäuse (10) und mit dem anderen Ende an der Kontakteinheit (12) befestigt ist.

6. HF-Messspitze nach mindestens einem der vorhergehenden Ansprüche, **dadurch gekennzeichnet, dass** der Innenleiter (18) über seine gesamte Länge zwischen dem Gehäuse (10) und der Kontakteinheit (12) von dem Hohlprofil (16) koaxial umgeben und von diesem beabstandet ist.

7. HF-Messspitze nach mindestens einem der vorhergehenden Ansprüche, **dadurch gekennzeichnet, dass** der Innenleiter (18) im Querschnitt vieleckig, rechteckig, dreieckig, oval oder rund ausgebildet ist.

8. HF-Messspitze nach mindestens einem der vorhergehenden Ansprüche, **dadurch gekennzeichnet, dass** das den Außenleiter (16) ausbildende Hohlprofil im Querschnitt vieleckig, rechteckig, dreieckig, oval oder rund ausgebildet ist.

9. HF-Messspitze nach mindestens einem der vorhergehenden Ansprüche, **dadurch gekennzeichnet, dass** der Außenleiter (16) als Rohr ausgebildet ist.

## Claims

1. HF test prod comprising a housing (10) and a contact unit (12) for electrically contacting at least one contact point of a specimen, wherein an HF coaxial line (14) that connects the housing (10) and the contact unit (12) electrically and mechanically is arranged between said housing and said contact unit, said line having an external conductor (16), an internal conductor (18) arranged coaxially to the external conductor (16), and a dielectric (20) arranged between the external conductor (16) and internal conductor (18), **characterised in that** the external conductor (16) is designed as a hollow profile section from a rigid, elastically deformable material, wherein the internal conductor (18) is arranged coaxially to said hollow profile section and the dielectric (20) is gas or vacuum.

2. HF test prod according to claim 1, **characterised in that** the HF coaxial line (14) possesses at least two or more internal conductors (18).

3. HF test prod according to claim 1 or 2, **characterised in that** the HF coaxial line (14) possesses at least two or more external conductors (16).

4. HF test prod according to at least one of the preceding claims, **characterised in that** the internal conductor (18) is arranged self-supportingly within the hollow profile section (16) over at least one predetermined section of the hollow profile section (16).

5. HF test prod according to at least one of the preceding claims, **characterised in that** one end of the internal conductor (18) is fixed to the housing (10) and the other end is fixed to the contact unit (12).

6. HF test prod according to at least one of the preceding claims, **characterised in that** the internal conductor (18) is surrounded coaxially by the hollow profile section (16) over its entire length between the housing (10) and the contact unit (12) and is arranged at a distance from this.

7. HF test prod according to at least one of the preceding claims, **characterised in that** the internal conductor (18) is polygonal, rectangular, triangular, oval or round in cross section.

8. HF test prod according to at least one of the preceding claims, **characterised in that** the hollow profile section forming the external conductor (16) is polygonal, rectangular, triangular, oval or round in cross section.

9. HF test prod according to at least one of the preceding claims, **characterised in that** the external conductor (16) is designed as a tube.

## Revendications

1. Pointe de mesure HF comprenant un boîtier (10) et une unité à contact (12) pour la mise en contact électrique d'au moins un emplacement de contact d'une pièce à contrôler, dans laquelle entre le boîtier (10) et l'unité à contact (12) est agencée une ligne coaxiale HF (14) qui relie ceux-ci sur le plan électrique et mécanique, ladite ligne comprenant un conducteur extérieur (16), un conducteur intérieur (18) agencé coaxialement par rapport au conducteur extérieur (16), et un diélectrique (20) agencé entre le conducteur extérieur (16) et le conducteur intérieur (18),
**caractérisée en ce que**
le conducteur extérieur (16) est réalisé sous forme de profilé creux en un matériau rigide élastiquement déformable, le conducteur intérieur (18) est agencé coaxialement à ce profilé creux, et le diélectrique (20) est formé de gaz ou de vide.

2. Pointe de mesure HF selon la revendication 1, **caractérisée en ce que** la ligne coaxiale HF (14) comprend au moins deux ou plusieurs conducteurs intérieurs (18).

3. Pointe de mesure HF selon la revendication 1 ou 2, **caractérisée en ce que** la ligne coaxiale HS (14) comprend au moins deux ou plusieurs conducteurs extérieurs (16).

4. Pointe de mesure HF selon l'une au moins des revendications précédentes, **caractérisée en ce que** le conducteur intérieur (18) est agencé, sur au moins un tronçon prédéterminé du profilé creux (16) de manière autoportante à l'intérieur du profilé creux (16).

5. Pointe de mesure HF selon l'une au moins des revendications précédentes, **caractérisée en ce que** le conducteur intérieur (18) est fixé avec une extrémité sur le boîtier (10) et avec l'autre extrémité sur l'unité à contact (12).

6. Pointe de mesure HF selon l'une au moins des revendications précédentes, **caractérisée en ce que** le conducteur intérieur (18) est entouré coaxialement par le profilé creux (16) et écarté de celui-ci sur la totalité de sa longueur entre le boîtier (10) et l'unité à contact (12).

7. Pointe de mesure HF selon l'une au moins des revendications précédentes, **caractérisée en ce que** le conducteur intérieur (18) est réalisé avec une section transversale polygonale, rectangulaire, triangulaire, ovale ou ronde.

8. Pointe de mesure HF selon l'une au moins des revendications précédentes, **caractérisée en ce que** le profilé creux qui forme le conducteur extérieur (16) est réalisé avec une section transversale polygonale, rectangulaire, triangulaire, ovale ou ronde.

9. Pointe de mesure HF selon l'une au moins des revendications précédentes, **caractérisée en ce que** le conducteur extérieur (16) est réalisé sous forme de tube.
